# EUROPEAN PATENT APPLICATION

(11) **EP 4 456 148 A1**
(43) Date of publication of application: **30.10.2024**
(21) Application number: 23746171.0
(22) Date of filing: 18.01.2023
(51) Int. Cl.: H01L 31/0224, H01L 31/0236

(54) **MANUFACTURING METHOD FOR HETEROJUNCTION BATTERY, HETEROJUNCTION BATTERY, AND PHOTOVOLTAIC ASSEMBLY**

(30) Priority: 25.01.2022 CN 202210087135; 25.01.2022 CN 202220208702 U; 25.01.2022 CN 202220208694 U
(71) Applicant: CSI Solar Technologies (Jiaxing) Co., Ltd., Jiaxing, Zhejiang 314001 (CN)
(72) Inventor: ZHANG, Daqi, Jiaxing, Zhejiang 314001 (CN); WU, Jian, Jiaxing, Zhejiang 314001 (CN); JIANG, Fangdan, Jiaxing, Zhejiang 314001 (CN)
(74) Representative: Murgitroyd & Company
(86) International application number: PCT/CN2023/072820
(87) International publication number: WO 2023/143289

(57) **Abstract**

A method for preparing a heterojunction cell, a heterojunction cell and a photovoltaic assembly are disclosed. The method for preparing the heterojunction cell includes: manufacturing a heterojunction cell; and irradiating a surface of the heterojunction cell using Ultraviolet (UV) light to obtain the heterojunction cell with a surface energy greater than 40mN/m.

## Description

### TECHNICAL FIELD

The present disclosure relates to the technical field of heterojunction cells, and more particularly, to a method for preparing a heterojunction cell, a heterojunction cell and a photovoltaic assembly.

### BACKGROUND

In the related technology, during preparation of a heterojunction cell, organic components of a slurry are prone to volatilize onto a surface of the heterojunction cell in a low-temperature drying and curing process, resulting in a decrease in the surface energy of the heterojunction cell. The decrease in the surface energy of the heterojunction cell results in a decrease in a peeling energy between the heterojunction cell and an encapsulating adhesive film layer, resulting in a risk of a reliability failure, especially in the outdoors where the heterojunction cell is affected by illumination, temperature changes, humidity and so on.

### SUMMARY

The present disclosure aims to solve at least one of the technical problems existing in the prior art. Therefore, a first purpose of the present disclosure is to propose a method for preparing a heterojunction cell, which can effectively improve the peeling energy between the heterojunction cell and the encapsulating adhesive film, and enhance the reliability of the connection between the encapsulating adhesive film and the heterojunction cell.

A second purpose of the present disclosure is to propose a heterojunction cell manufactured using the method for preparing the heterojunction cell described above.

A third purpose of the present disclosure is to propose a photovoltaic assembly including the heterojunction cell in the embodiments described above.

A method for preparing a heterojunction cell according to an embodiment in a first aspect of the present disclosure includes the following steps:
manufacturing a heterojunction cell;
irradiating a surface of the heterojunction cell using Ultraviolet (UV) light to obtain the heterojunction cell with a surface energy greater than 40mN/m.

According to the method for preparing the heterojunction cell of the present disclosure, the UV light can better remove the organic dirt on a surface of the heterojunction cell, so as to enhance the surface energy of the heterojunction cell, and obtain the heterojunction cell with a surface energy greater than 40mN/m. Moreover, it can effectively improve the peeling energy between the heterojunction cell and the encapsulating adhesive film, and enhance the reliability of the connection between the encapsulating adhesive film and the heterojunction cell.

In some examples of the present disclosure, the irradiating the surface of the heterojunction cell using the UV light includes: irradiating the surface of the heterojunction cell using a single type of UV light or a combination of multiple types of UV light.

In some examples of the present disclosure, the irradiating the surface of the heterojunction cell using the single type of UV light includes: irradiating the surface of the heterojunction cell using a single type of Ultraviolet C (UVC).

In some examples of the present disclosure, the irradiating the surface of the heterojunction cell using the single type of UV light includes: irradiating the surface of the heterojunction cell using a single type of UVC with a radiation intensity in a range of 100W/m² to 500W/m².

In some examples of the present disclosure, in the step of irradiating the surface of the heterojunction cell using the single type of UV light, a duration of irradiation using the single type of UVC is t₁, t₁ satisfying a relationship of 10min≤t₁≤60min; and/or an ambient temperature is T₁, T₁ satisfying a relationship of 20°C ≤ T₁ ≤ 200°C.

In some examples of the present disclosure, the irradiating the surface of the heterojunction cell using the combination of multiple types of UV light includes: irradiating the surface of the heterojunction cell using Ultraviolet A (UVA) and Ultraviolet B (UVB) or using Ultraviolet C (UVC) of different wavelengths.

In some examples of the present disclosure, the irradiating the surface of the heterojunction cell using the UVA and the UVB includes: irradiating the surface of the heterojunction cell using the UVA with a radiation intensity in a range of 100W/m² to 500W/m² and the UVB with a radiation intensity in a range of 100W/m² to 500W/m².

In some examples of the present disclosure, in the step of irradiating the surface of the heterojunction cell using the UVA and the UVB, a duration of irradiation using the UVA and the UVB is t₂, t₂ satisfying a relationship of 1day≤t₂≤7day; and/or an ambient temperature is T₂, T₂ satisfying a relationship of 20°C ≤ T₂ ≤ 200°C.

In some examples of the present disclosure, the irradiating the surface of the heterojunction cell using the UVC of different wavelengths includes: irradiating the surface of the heterojunction cell using UVC having a first wavelength and a radiation intensity in a range of 5W/m² to 30W/m² and UVC having a second wavelength and a radiation intensity in a range of 100W/m² to 500W/m², the first wavelength being less than the second wavelength.

In some examples of the present disclosure, in the step of irradiating the surface of the heterojunction cell using the UVC of different wavelengths, a irradiation duration of irradiation using the UVC of different wavelengths is t₃, t₃ satisfying a relationship of 1min≤t₃≤20min; and/or an ambient temperature is T₃, T₃ satisfying a relationship of 20°C ≤ T₃ ≤ 120°C.

In some examples of the present disclosure, the method further includes: after the irradiating the surface of the heterojunction cell using the UV light, performing an optical and thermal treatment on the heterojunction cell; and testing and sorting the heterojunction cell.

In some examples of this disclosure, manufacturing the heterojunction cell includes: manufacturing a cell body; depositing a transparent conductive film layer on a front surface and a back surface of the cell body; providing a metal electrode on a surface of the transparent conductive film layer; and drying and curing the metal electrode.

An heterojunction cell according to an embodiment in the second aspect of the present disclosure is manufactured using the method for preparing a heterojunction cell as described above. The heterojunction cell includes: a cell body, a transparent conductive film layer, and a metal electrode. The transparent conductive film layer is disposed on the cell body, a surface at one side of the transparent conductive film layer that faces away from the cell body is an electrode fixing surface. The electrode fixing surface has a surface energy that is greater than or equal to 40mN/m. The metal electrode is provided on the electrode fixing surface.

In some examples of the present disclosure, the electrode fixing surface has a surface energy that is greater than or equal to 60mN/m and that is less than or equal to 80mN/m.

In some examples of this disclosure, the cell body has a light-receiving surface and a backlighting surface. The transparent conductive film layer includes a first transparent conductive film layer and a second transparent conductive film layer. The first transparent conductive film layer is provided on the light-receiving surface, and the second transparent conductive film layer is provided on the backlighting surface. A surface at one side of the first transparent conductive film layer that faces away from the light-receiving surface is a first electrode fixing surface, a surface at one side of the second transparent conductive film layer that faces away from the backlighting surface is a second electrode fixing surface. The first electrode fixing surface has a surface energy greater than or equal to 40mN/m; and/or the second electrode fixing surface has a surface energy greater than or equal to 40mN/m.

In some examples of this disclosure, the cell body includes a silicon substrate and an amorphous silicon layer. The amorphous silicon layer is disposed on the silicon substrate, the transparent conductive film layer is disposed on the amorphous silicon layer. A surface of the silicon substrate is a textured surface, and the textured surface has an average size of less than 2µm.

In some examples of the present disclosure, the textured surface has an average size greater than or equal to 1.3µm and less than or equal to 1.7µm.

A photovoltaic assembly according to an embodiment in a third aspect of the present disclosure, includes the heterojunction cell as described in any of the above examples.

The additional aspects and advantages of the present disclosure will be partially provided in the following description, and will partially become apparent from the following description or will be learned through the practice of this application.

### BRIEF DESCRIPTION OF DRAWINGS

The above and/or additional aspects and advantages of the present disclosure will become apparent and easy to understand from the description of embodiments in conjunction with the accompanying drawings, in which:
FIG. 1 is a flowchart diagram of a method for preparing a heterojunction cell according to an embodiment of the present disclosure;
FIG. 2 is a schematic diagram of a heterojunction cell according to an embodiment of the present disclosure;
FIG. 3 is a schematic diagram of a photovoltaic assembly according to an embodiment of the present disclosure.

### Reference numerals:

100: Photovoltaic assembly;
10: Cover plate; 11: First cover plate; 12: Second cover plate;
20: Encapsulating adhesive film layer; 21: First encapsulating adhesive film layer; 22: Second encapsulating adhesive film layer;
30: Heterojunction cell; 31: Cell body; 310: Light-receiving surface; 311: Backlighting surface; 312: Silicon substrate; 313: Amorphous silicon layer; 32: Transparent conductive film layer; 320: First transparent conductive film layer; 321: Second transparent conductive film layer; 33: Metal electrode; 34: Electrode fixing surface; 341: First electrode fixing surface; 342: Second electrode fixing surface.

### DESCRIPTION OF EMBODIMENTS

Embodiments of the present disclosure will be described in detail below, and the embodiments described with reference to the accompanying drawings are exemplary. Embodiments of the present disclosure will be described in detail below.

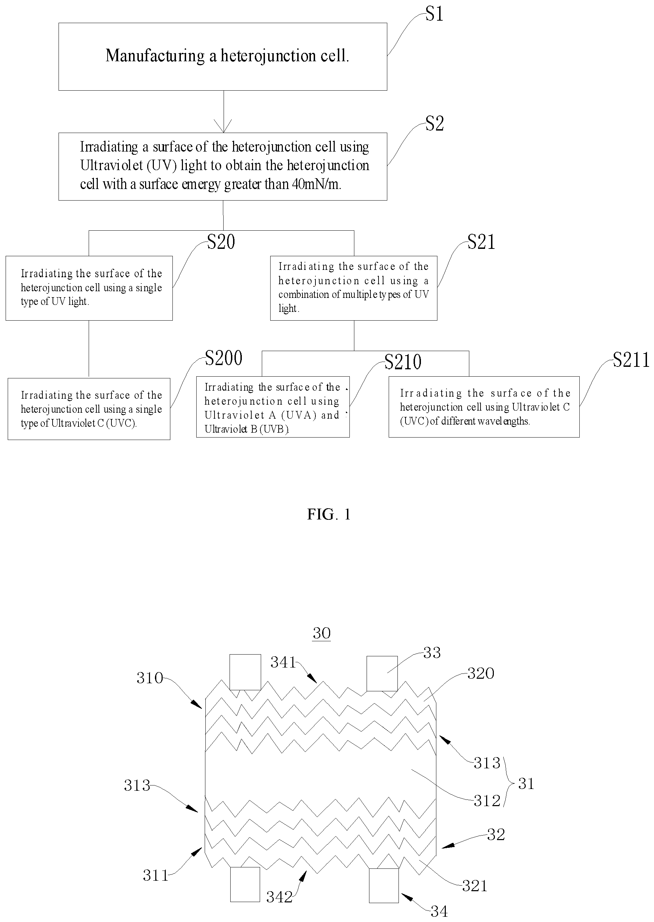

A method for preparing a heterojunction cell 30 according to an embodiment of this disclosure, as well as a heterojunction cell 30 prepared by the method and a photovoltaic assembly 100 including the heterojunction cell 30 are described below with reference to FIG. 1 to FIG. 3.

As shown in FIG. 1, the method for preparing a heterojunction cell 30 according to an embodiment of the present disclosure includes the following steps.

At S1, a heterojunction cell 30 is manufactured. Specifically, manufacturing the heterojunction cell 30 includes manufacturing a cell body 31, depositing a transparent conductive film layer 32 on a front surface and a back surface of the cell body 31, providing a metal electrode 33 on a surface of the transparent conductive film layer 32, and drying and curing the metal electrode 33. The cell body 31 includes a silicon substrate 312 and an amorphous silicon layer 313 to manufacture the cell body 31, which can form the main part of the heterojunction cell 30. The transparent conductive film layer 32 is deposited on the front surface and the back surface of the cell body 31, and the metal electrode 33 is provided on a surface of the transparent conductive film layer 32. For example, the metal electrode 33 can be set on a surface of the transparent conductive film layer 32 by means of screen printing, electroplating, or laser transfer printing, and the transparent conductive film layer 32 can cooperates with the metal electrodes 33 to achieve the conductive function of the heterojunction cell 30. Furthermore, drying and curing the metal electrodes 33 can ensure the stability of the connection between the metal electrodes 33 and the transparent conductive film layer 32, so as to ensure the normal conductive function of the metal electrode 33.

At S2, a surface of the heterojunction cell 30 is irradiated using Ultraviolet (UV) light to obtain the heterojunction cell 30 with a surface energy greater than 40mN/m. In other words, after the heterojunction cell 30 is manufactured, a surface of the heterojunction cell 30 can be irradiated by the UV light, and the UV light can better remove the organic dirt on the surface of the heterojunction cell 30, so as to enhance the surface energy of the heterojunction cell 30, and obtain the heterojunction cell 30 with a surface energy greater than 40mN/m. Moreover, this can effectively improve the peeling energy between the heterojunction cell 30 and the encapsulating adhesive film layer, and enhance the reliability of the connection between the encapsulating adhesive film layer and the heterojunction cell 30.

As shown in FIG. 1, the step S2 includes a step S20.

At S20, the surface of the heterojunction cell 30 is irradiated using a single type of UV light. That is, the surface of the heterojunction cell 30 is irradiated by only one single type of UV light to remove the organic dirt on the surface of the heterojunction cell 30. In this way, the operation is simpler and more convenient.

Further, as shown in FIG. 1, the step S20 includes a step S200.

At S200, the surface of the heterojunction cell 30 is irradiated using a single type of Ultraviolet C (UVC, as a short wave ultraviolet). It should be noted that UVC is a part of UV light with a shorter wavelength, and the wavelength of UVC is in a range between 200nm to 280nm. After irradiating the surface of the heterojunction cell 30 using UVC, the organic dirt on the surface of the heterojunction cell 30 can be better removed and the surface energy of the heterojunction cell 30 can be improved. Moreover, this can effectively improve the peeling energy between the heterojunction cell 30 and the encapsulating adhesive film layer, and enhance the reliability of the connection between the encapsulating adhesive film layer and the heterojunction cell 30.

Optionally, the step S20 includes: irradiating the surface of the heterojunction cell 30 using a single type of UVC with a radiation intensity in a range of 100W/m² to 500W/m². Setting the radiation intensity of the single type of UVC in a range of 100W/m² to 500W/m² can better meet the radiation requirements of the single type of UVC for the surface of the heterojunction cell 30, so that the irradiation effect of the single type of UVC is better, avoiding a too low radiation intensity which results in an inapparent effect of removing organic dirt on the surface of the heterojunction cell 30, and avoiding a too high radiation intensity which may result in a negative effect on the overall structure and performance of the heterojunction cell 30.

Optionally, in the step S20, a duration of irradiation using the single type of UVC is t₁, t₁ satisfies a relationship of 10min≤t₁≤60min. That is, a duration of irradiation of the single type of UVC also needs to meet a certain condition. The duration of irradiation is preferably in a range of 10min to 60min. Similarly, this can make the irradiation effect of the single type of UVC better, avoids a too short irradiation duration which results in an inapparent effect of removing organic dirt on the surface of the heterojunction cell 30, and avoids a too long irradiation duration which may lead to a negative effect on the overall structure and performance of the heterojunction cell 30.

Optionally, in the step S20, an ambient temperature is T₁, T₁ satisfies a relationship of 20°C ≤ T₁ ≤ 200°C. When the ambient temperature is greater than or equal to 20°C, and less than or equal to 200°C, the single type of UVC can better act on the surface of the heterojunction cell 30, and thus can better remove the organic dirt on the surface of the heterojunction cell 30.

According to an optional embodiment of the present disclosure, as shown in FIG. 1, the step S2 includes a step S21.:
At S21, the surface of the heterojunction cell 30 is irradiated using a combination of multiple types of UV light. That is to say, the surface of the heterojunction cell 30 is irradiated by a combination of different types of UV light, which can also remove the organic dirt on the surface of the heterojunction cell 30, and achieve a different effect, so that it can respond to the needs of different situations.

As shown in FIG. 1, the step S21 includes a step S210.

At S210, the surface of the heterojunction cell 30 is irradiated using UVA (long-wave black spot effect ultraviolet light) and UVB (outdoor ultraviolet light). It should be noted that UVA is a part of the UV light having a longer wavelength, with the wavelength being in a range between 320nm and 400nm; and UVB is a part of the UV light having the wavelength in an intermediate range, with the wavelength being in a range of 280nm to 320nm. After irradiating the surface of the heterojunction cell 30 using UVA and UVB, the organic dirt on the surface of the heterojunction cell 30 can also be effectively removed under certain circumstances, and the surface energy of the heterojunction cell 30 can be improved, thereby effectively improving the peeling energy between the heterojunction cell 30 and the encapsulating adhesive film layer, and enhancing the reliability of the connection between the encapsulating adhesive film layer and the heterojunction cell 30.

Further, the step S210 includes: irradiating the surface of the heterojunction cell 30 using the UVA with a radiation intensity in a range of 100W/m² to 500W/m² and the UVB with a radiation intensity in a range of 100W/m² to 500W/m². The radiation intensities of both the UVA and the UVB can set in a range of 100W/m² to 500W/m², so as to better meet the radiation requirements of the UVA and the UVB for the surface of the heterojunction cell 30, make the irradiation effect of the UVA and the UVB better, avoid a too low radiation intensity which will cause an inapparent effect of removing organic dirt on the surface of the heterojunction cell 30, and avoid a too high radiation intensity which may lead to a negative effect on the overall structure and performance of the heterojunction cell 30.

The UVB, in the step S210, a duration of irradiation using the UVA and the UVB is t₂, and t₂ satisfies a relationship of 1day≤t₂≤7days. That is to say, the duration of irradiation of the UVA and the UVB also needs to meet a certain condition, and the duration of irradiation is preferably in a range of 1 day to 7 days. Similarly, this can make the irradiation effect of the UVA and the UVB better, avoids a too short irradiation duration which results in an inapparent effect of removing organic dirt on the surface of the heterojunction cell 30, and avoids a too long irradiation duration which may lead to a negative effect on the overall structure and performance of the heterojunction cell 30.

The UVB, in the step S210, an ambient temperature is T₂, and T₂ satisfies a relationship of 20°C ≤ T₂ ≤ 200°C. When the ambient temperature is greater than or equal to 20°C, and is less than or equal to 200°C, the UVA and the UVB can better act on the surface of the heterojunction cell 30, so that the organic dirt on the surface of the heterojunction cell 30 can be better removed.

Optionally, as shown in FIG. 1, the step S21 includes a step S211.

At S211, the surface of the heterojunction cell 30 is irradiated using Ultraviolet C (UVC) of different wavelengths. After the surface of the heterojunction cell 30 is irradiated with UVC of different wavelengths, the organic dirt on the surface of the heterojunction cell 30 can also be effectively removed under certain circumstances , and the surface energy of the heterojunction cell 30 can be enhanced, so as to effectively improve the peeling energy between the heterojunction cell 30 and the encapsulating adhesive film layer, and enhance the reliability of the connection between the encapsulating adhesive film layer and the heterojunction cell 30.

Specifically, the step S211 includes: irradiating the surface of the heterojunction cell 30 using UVC having a first wavelength and a radiation intensity in a range of 5W/m² to 30W/m² and UVC having a second wavelength and a radiation intensity in a range of 100W/m² to 500W/m². The first wavelength is less than the second wavelength. In other words, the radiation intensity of the UVC with a smaller wavelength is set to be in a range of 5W/m² to 30W/m², and the radiation intensity of the UVC with a larger wavelength is set to in a range of 100W/m² to 500W/m². This setting is more reasonable, and can better meet the radiation requirements of UVC of different wavelengths for the surface of the heterojunction cell 30, and can make the irradiation effect of UVC with the different wavelengths better, so as to avoid a too small radiation intensity which results in an inapparent effect of removing organic dirt on the surface of the heterojunction cell 30, and to avoid a too much radiation intensity which may lead to a negative effect on the overall structure and performance of the heterojunction cell 30. The first wavelength is preferably 185nm, the second wavelength is preferably 254nm, and the UVC light of the first wavelength and the UVC light of the second wavelength are emitted from a same light source at the same time.

The UVB, in the step S211, a duration of irradiation using the UVC of different wavelengths is t₃, and t₃ satisfies a relationship of 1min≤t₃≤20min. That is to say, the duration of irradiation of the UVC of different wavelengths also needs to meet a certain condition, and the duration of irradiation is preferably in a range of 1 minute to 20 minutes. Similarly, this can make the irradiation effect of UVC with the different wavelengths better, avoid a too short irradiation duration which results in an inapparent effect of removing organic dirt on the surface of the heterojunction cell 30, and avoid a too long irradiation duration which may lead to a negative effect on the overall structure and performance of the heterojunction cell 30.

The UVB, in the step S211, an ambient temperature is T₃, and T₃ satisfies a relationship of 20°C ≤ T₃ ≤ 120°C. The ambient temperature needs to be greater than or equal to 20°C. When the UVC of different wavelengths irradiates the surface of the heterojunction cell 30, the structure of the heterojunction cell 30 will be destroyed if the ambient temperature is too high, therefore the ambient temperature needs to be less than or equal to 120°C. This allows the UVC of different wavelengths to better act on the surface of the heterojunction cell 30, so that the organic dirt on the surface of the heterojunction cell 30 can be better removed.

According to an optional embodiment of the present disclosure, after the step S2, the method includes a following step of:
performing an optical and thermal treatment on the heterojunction cell 30, and testing and sorting the heterojunction cell 30.

The optical and thermal treatment can enhance the efficiency of the heterojunction cell 30, as well as repair the defects of the heterojunction cell 30. If the UV light irradiation causes a damage to the heterojunction cell 30 and results in a decrease in the efficiency of the heterojunction cell 30, the optical and thermal treatment can be carried out after the UV light irradiation. Testing and sorting the heterojunction cell 30 can be performed so as to test the performance of the heterojunction cell 30 and to select the heterojunction cell 30 that meets a requirement. In this way, the excellent rate of the heterojunction cell 30 can be enhanced.

According to another optional embodiment of the present disclosure, after the step S 1 and before the step S2, the method further includes a step of: performing an optical and thermal treatment on the heterojunction cell 30.

After the step S2, the method further includes: testing and sorting the heterojunction cell 30.

In other words, the UV light irradiation is performed between the optical and thermal treatment on the heterojunction cell 30 and the testing and sorting of the heterojunction cell 30, which can be realized by simple modification of an existing production line. UV light irradiation is performed before testing and sorting, so that even if the efficiency of the heterojunction cell 30 changes in the process of the light irradiation, unqualified heterojunction cells 30 can be separated by testing and sorting, instead of being mixed together.

According to still another optional embodiment of the present disclosure, after the step S 1 and before the step S2, the method further includes a following step of:
performing an optical and thermal treatment on the heterojunction cell 30, and testing and sorting the heterojunction cell 30.

In other words, the optical and thermal treatment on the heterojunction cell 30 and the testing and sorting of the heterojunction cell 30 are performed between the step S1 and the step S2, so that a relevant equipment can be added directly, and any modification to the existing production line is not needed.

According to yet another optional embodiment of the present disclosure, an optical and thermal treatment on the heterojunction cell 30 is performed synchronously during the step S2.

After the step S2, the method further includes a following step of: testing and sorting the heterojunction cell 30.

That is, in the process of performing an optical and thermal treatment on the heterojunction cell 30, the UV light irradiation can be integrated into the photo-thermal furnace for the optical and thermal treatment.

Further, the step S2 includes: emitting UV light using one of a single-wavelength laser, a low-pressure mercury lamp, and a xenon lamp. The single-wavelength laser, the low-pressure mercury lamp, or the xenon lamp may be used to emit UV light. The wavelengths of UV light emitted by the single-wavelength laser, the low-pressure mercury lamp, and the xenon lamp may be different, so that UV light emitted by the single-wavelength laser, the low-pressure mercury lamp, and the xenon lamp can be combined to achieve different effects.

The following is a detailed description of a test method of a surface energy of the heterojunction cell 30.

For the heterojunction cell 30, liquids with different surface energy values are selected to be respectively applied onto the surfaces of the heterojunction cell 30 via brush coating. The expansion or contraction of the liquids within 5 seconds is observed. If the surface energy of the heterojunction cell 30 is less than or equal to the surface energy value of the liquid, the ink does not expand or contract. If the surface energy of the heterojunction cell 30 is greater than the surface energy value of the liquid, the ink expands. The upper limit of the surface energy of the test liquid is 72mN/m.

Preparation process: texturing, chemical vapor deposition (CVD), physical vapor deposition (PVD), screen printing, low-temperature drying, curing, optical and thermal processing, and testing and sorting are performed to prepare the heterojunction cell 30, and then the surface of the heterojunction cell 30 is irradiated by UV light to improve the surface energy of the irradiated surface.

Here, the heterojunction cell 30 has an initial surface energy of 34mN/m at the irradiated surface.

Example 1: the surface of the heterojunction cell 30 is irradiated using UVA and UVB. Here, the ambient temperature is 85°C, the UVB with 8W/m² and the UVA with 142W/m² are used, UVC is not used, and the irradiation duration is 12h, and the surface energy of the irradiated surface of the heterojunction cell 30 can be raised to 50mN/m.

Example 2: the surface of the heterojunction cell 30 is irradiated using UVA and UVB. Here, the ambient temperature is 85°C, the UVB with 120W/m² and the UVA with 30W/m² are used, UVC is not used, the irradiation duration is 12h, and the surface energy of the irradiated surface of the heterojunction cell 30 can be raised to 66mN/m.

Example 3: a single type of UVC is used to irradiate the surface of the heterojunction cell 30. Here, the ambient temperature is 85°C, the UVC with 150W/m² and with a wavelength of 254nm is used, the irradiation duration is 12h, and the surface energy of the irradiated surface of the heterojunction cell 30 can be raised to greater than 72mN/m.

Example 4: UVC with different wavelengths is used to irradiate the surface of the heterojunction cell 30. Here, the ambient temperature is 85°C, UVC with 150W/m² and with a first wavelength of 185nm and UVC with 150W/m² and with a second wavelength of 254nm are used, the irradiation duration is 1 min, and the surface energy of the irradiated surface of the heterojunction cell 30 can be raised to 68mN/m.

**Table 1 Improvement of surface energy of the irradiated surface of heterojunction cell 30 with different UV light**

| Sample | surface energy (mN/m)of the irradiated surface of the heterojunction cell 30 | photovoltaic conversion efficiency (%) of the irradiated surface of the heterojunction cell 30 |
|---|---|---|
| Comparative example | 34 | 24.38 |
| Example 1 | 50 | 24.35 |
| Example 2 | 66 | 24.37 |
| Example 3 | greater than 72 | 24.39 |
| Example 4 | 68 | 24.39 |

From the results in Table 1 above, it can be seen that UV with a shorter wavelength can achieve a more effective effect of removal of organic dirt on the surface of the heterojunction cell 30, which is reflected in a larger increase in the surface energy of the heterojunction cell 30. At the same time, UV light with a shorter wavelength is easier to be absorbed by the ITO (Indium Tin Oxide), that is, is less easy to penetrate to the amorphous silicon passivation interface, and therefore generates a less influence on the efficiency of the heterojunction cell 30. In addition, due to the removal of organic dirt on the surface of the heterojunction cell 30, the Isc (short circuit current) of the heterojunction cell 30 is slightly increased.

Of course, increasing the radiation intensity and ambient temperature within a certain range can also shorten the irradiation time and enable the heterojunction cell 30 to reach a high surface energy state.

It should be noted that, when printing the HJT cell (heterojunction cell 30) using a low-temperature slurry, because the thermal volatilization of solvents and resins in low-temperature slurry during the preparation process would result in organic contamination on the surface of the heterojunction cell 30, the low-temperature slurry may be selected as a pure silver slurry or a silver-coated copper slurry or the like. Therefore, when the heterojunction cell 30 is prepared by methods such as copper plating and laser transfer, and the initial surface energy thereof is low, the surface energy of the heterojunction cell 30 can be enhanced using the method of UV light irradiation.

As shown in FIG. 2, a heterojunction cell 30 according to an embodiment in a second aspect of the present disclosure is made using the method for preparing the heterojunction cell 30 described in any of the above embodiments.

Specifically, the heterojunction cell 30 includes: a cell body 31, a transparent conductive film layer 32, and a metal electrode 33. The cell body 31 is a main part of the heterojunction cell 30. The transparent conductive film layer 32 cooperate with the metal electrode 33, so that the conductive function of the heterojunction cell 30 can be realized.

As shown in FIG. 2, the transparent conductive film layer 32 is provided on the cell body 31, so that the transparent conductive film layer 32 can be connected with the cell body 31 and can act on the heterojunction cell 30 to play a role of electric conduction. A surface at one side of the transparent conductive film layer 32 that faces away from the cell body 31 is an electrode fixing surface 34, the electrode fixing surface 34 can be used to fix the metal electrode 33. The metal electrode 33 can be provided on the electrode fixing surface 34, so that the metal electrode 33 can be better connected with the transparent conductive film layer 32 to better cooperate with the transparent conductive film layer 32.

It should be noted that the surface energy refers to a non-volume work done to an object that is needed for reversibly increasing a surface area of the object under the condition of constant temperature, constant pressure, and constant composition. The surface energy value of the electrode fixing surface 34 is greater than or equal to 40mN/m, which can ensure that the surface energy of the electrode fixing surface 34 is maintained in a reliable range. In this way, in the preparation process of the heterojunction cell 30, it can avoid that the surface energy of the electrode fixing surface 34 decreases and thus avoid a decrease in the peeling energy between the encapsulating adhesive film layer and the transparent conductive film layer 32, and thus a reduction in the reliability of the connection between the encapsulating adhesive film layer and the heterojunction cell 30.

The surface energy value of the electrode fixing surface 34 is greater than or equal to 40mN/m and less than or equal to 80mN/m. As described above, the surface energy value of the electrode fixing surface 34 is greater than or equal to 40mN/m, so that the surface energy of the electrode fixing surface 34 remains in a reliable range, avoiding a decrease in the peel energy between the encapsulating adhesive film layer 20 and the transparent conductive film layer 32 and thus a reduction in the reliability of the connection between the encapsulating adhesive film layer 20 and the heterojunction cell 30.

Further, the surface energy value of the electrode fixing surface 34 is greater than or equal to 60mN/m and less than or equal to 80mN/m. Of course, the surface energy value of the electrode fixing surface 34 may be greater than or equal to 60mN/m, and preferably the surface energy value of the electrode fixing surface 34 is greater than or equal to 70mN/m. In this way, while ensuring that the surface energy is stabilized, the connection reliability of the encapsulating adhesive film layer and the heterojunction cell 30 can be improved.

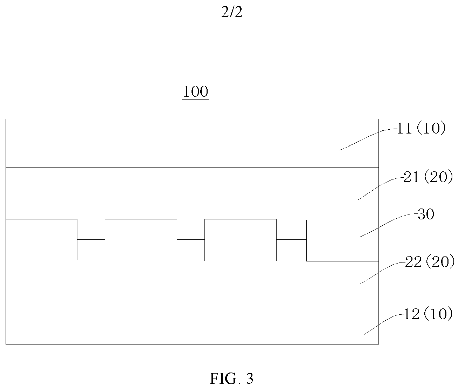

In some examples of the present disclosure, as shown in FIG. 3, the cell body 31 has a light-receiving surface 310 and a backlighting surface 311. The transparent conductive film layer 32 includes a first transparent conductive film layer 320 and a second transparent conductive film layer 321. The first transparent conductive film layer 320 is disposed on the light-receiving surface 310, and the second transparent conductive film layer 321 is disposed on the backlighting surface 311. A surface at one side of the first transparent conductive film layer 320 that faces away from the light-receiving surface 310 is a first electrode fixing surface 341, and a surface at one side of the second transparent conductive film layer 321 that faces away from the backlighting surface 311 is a second electrode fixing surface 342. The first electrode fixing surface has a surface energy value greater than or equal to 40mN/m.

It can be understood that, the cell body 31 or the heterojunction cell 30 has two surfaces, with the surface that primarily receives sunlight being a front surface, i.e., the light-receiving surface 310, and another surface opposite to the front surface is a surface of the cell body 31 or the heterojunction cell 30 that secondarily receiving sunlight, i.e., the backlighting surface 311. The first transparent conductive film layer 320 may cooperate with the metal electrode 33 disposed on one side of the light-receiving surface 310 to play a role of electric conduction on the light-receiving surface 310 of the cell body 31. The second transparent conductive film layer 321 may cooperate with the metal electrode 33 disposed on one side of the backlighting surface 311 to play a role of electric conduction on the backlighting surface 311 of the cell body 31. The surface energy value of the first electrode fixing surface 341 is greater than or equal to 40mN/m, so that the surface energy of the first electrode fixing surface 341 can remain in a reliable range, avoiding a decrease in the peeling energy between the first transparent conductive film layer 320 and the encapsulating adhesive film layer disposed on the side of the light-receiving surface 310, and a decrease in the reliability of the connection between the heterojunction cell 30 and the encapsulating adhesive film layer 20 disposed on the side of the light-receiving surface 310.

In addition, as shown in FIG. 3, the surface at one side of the second transparent conductive film layer 321 that faces away from the backlighting surface 311 is a second electrode fixing surface 342, and the second electrode fixing surface has a surface energy value greater than or equal to 40mN/m. Similarly, the surface energy of the second electrode fixing surface 342 can be kept in a reliable range, avoiding a decrease in the peeling energy between the second transparent conductive film layer 321 and the encapsulating adhesive film layer 20 disposed on the side of the backlighting surface 311, and a decrease in the reliability of the connection between the heterojunction cell 30 and the encapsulating adhesive film layer 20 disposed on the side of the backlighting surface 311.

In some examples of the present disclosure, the transparent conductive film layer 32 is a transparent conductive film layer 32 in which the mass concentration of indium trioxide is greater than 90%. It should be noted that the main components of the transparent conductive film layer 32 are indium trioxide and tin dioxide. Indium trioxide is a new n-type transparent semiconductor functional material with a wide band gap, a smaller resistivity, and higher catalytic activity, and is widely used in the fields of optoelectronics, gas sensors, and catalysts. The mass concentration of indium trioxide in the transparent conductive film layer 32 is greater than 90%, which can make the transparent conductive film layer 32 have better relevant performance and achieve a better transparent and conductive effect. In addition, the surface energy of the transparent conductive film layer 32 can be improved to a certain extent, and the decline degree of the surface energy of the electrode fixing surface 34 during the preparation process of the heterojunction cell 30 can be reduced.

Optionally, the transparent conductive film layer 32 is a transparent conductive film layer 32 in which the mass concentration of indium trioxide is greater than 95%. The mass concentration of indium trioxide in the transparent conductive film layer 32 being set to be greater than 95% generates a better relevant performance of the transparent conductive film layer 32 and a better transparent conductive effect, further improves the surface energy of the transparent conductive film layer 32, reduces the decline degree of the surface energy of the electrode fixing surface 34 during the preparation process of the heterojunction cell 30.

In some examples of the present disclosure, the cell body 31 includes a silicon substrate 312 and an amorphous silicon layer 313. The amorphous silicon layer 313 is disposed on the silicon substrate 312. The transparent conductive film layer 32 is disposed on the amorphous silicon layer 313, the surface of the silicon substrate 312 is a textured surface, and the average size of the textured surface is less than 2µm. The silicon substrate 312 is made from a material used for production of a heterojunction cell. The amorphous silicon layer 313 is provided on the silicon substrate 312. The amorphous silicon layer 313 is provided on the light-receiving surface 310 and the backlighting surface 311 of the silicon substrate 312 at the same time, so that both the light-receiving surface 310 and the backlighting surface 311 of the silicon substrate 312 can form the crystalline silicon substrate 312. The surface of the silicon substrate 312 is set as a textured surface, and the average size of the textured surface is less than 2µm. It is to be noted that, the textured surface of this size, compared to a polished surface with the same size, is easier to achieve high surface energy after UV irradiation. Therefore, it can avoid a decrease in the peeling energy between the encapsulating adhesive film layer and the transparent conductive film layer 32, and thus avoid a reduction in the reliability of the connection between the encapsulating adhesive film layer and the heterojunction cell 30.

Further, the average size of the textured surface is greater than or equal to 1.3 µm and less than or equal to 1.7 µ m. Thereby, the range of the average size of the textured surface is defined, so that the average size of the textured surface is more reasonable, and it is easier for the textured surface to achieve a high surface energy, thereby avoiding a decrease in the peeling energy between the encapsulating adhesive film layer 20 and the transparent conductive film layer 32, and thus avoid a reduction in the reliability of the connection between the encapsulating adhesive film layer 20 and the heterojunction cell 30

It should be noted that the size of the textured surface is a Feret diameter of a pyramid. Within a unit area of the light-receiving surface 310 of the silicon substrate 312, a percentage of the number of pyramids with a Feret diameter in a range of 1µm to 1.5µm is 20% to 40%, a percentage of the number of pyramids with a Feret diameter in a range of 1.5µm to 2µm is 20% to 40%. Furthermore, within a unit area of the light-receiving surface 310 of the silicon substrate 312, a percentage of the number of pyramids with a Feret diameter of less than 1µm is no greater than 10%, a percentage of the number of pyramids with a Feret diameter in the range of 2µm to 2.5µm is 5% to 25%, and a percentage of the number of pyramids with a Feret diameter greater than 2.5µm is less than 5%. Preferably, on the receiving surface 310 of the silicon substrate 312, the Feret diameter of each of the pyramids is not greater than 3µm.

Within a unit area of the backlighting surface 311 of the silicon substrate 312, a percentage of the number of pyramids with a Feret diameter in the range of 1.5µm to 2µm is 10% to 30%, a percentage of the number of pyramids with a Feret diameter in the range of 2µm to 2.5µm is 20% to 40%. Further, within a unit area of the backlighting surface 311 of the silicon substrate 312, a percentage of the number of pyramids with a Feret diameter less than 1µm is no greater than 10%, a percentage of the number of pyramids with a Feret diameter in the range of 1µm to 1.5µm is 10% to 20%, a percentage of the number of pyramids with a Feret diameter in the range of 2.5µm to 3µm is 5% to 20%, and a percentage of the number of pyramids with a Feret diameter greater than 3µm is less than 5%. Preferably, on the backlighting surface 311 of the silicon substrate 312, the Feret diameter of each of the pyramids is not greater than 4µm.

From the above, multiplying the number of pyramids in different diameter ranges by corresponding diameters respectively to obtain a value and then dividing the value by the total number of pyramids can obtain the average size of the textured surface. The average size of the textured surface is greater than or equal to 1.3µm and the average size of the textured surface is less than or equal to 1.7µm.

The following is a detailed description of the test method for the surface energy of the heterojunction cell 30.

Inks with different surface energy values are selected to be respectively applied onto the surface of the heterojunction cell 30 via brush coating. The expansion or contraction of the inks within 5 seconds is observed. If the surface energy of the heterojunction cell 30 is less than or equal to the surface energy value of the ink, the ink does not expand or contract. If the surface energy of the heterojunction cell is greater than the surface energy value of the ink, the ink expands. The upper limit of the surface energy of the text ink is 72mN/m.

Preparation process: the heterojunction cell 30 can be prepared by texturing, chemical vapor deposition (CVD), physical vapor deposition (PVD), screen printing, low-temperature drying, curing, and optical and thermal processing.

The heterojunction cell 30 having a high surface energy is realized by post-treatment, mainly by using a certain method to decompose the organic matter adsorbed on the surface of the heterojunction cell 30, including high-temperature treatment, ultraviolet (UV) illumination, plasma (plasma) treatment, and ozone (O₃) oxidation and so on.

The light-receiving surface 310 of the heterojunction cell 30 has an initial surface energy of 34mN/m, and the backlighting surface 311 has a surface energy of 34mN/m.

Post-treatment 1: the light-receiving surface 310 of the heterojunction cell 30 is irradiated by UV with 150W/m² at 60°C for a duration of 12h. The surface energy of the light-receiving surface 310 of the heterojunction cell 30 is enhanced to 48mN/m, and the surface energy of the backlighting surface 311 of the heterojunction cell 30 remains unchanged.

Post-treatment 2: the light-receiving surface 310 of the heterojunction cell 30 is irradiated by UV with 150W/m² at 60°C for a duration of 48h, the surface energy of the light-receiving surface 310 of the heterojunction cell 30 is enhanced to 58mN/m, and the surface energy of the backlighting surface 311 of the heterojunction cell 30 remains unchanged.

Post-treatment 3: the light-receiving surface 310 of the heterojunction cell 30 is irradiated by UV with 150W/m² at 60°C for a duration of 168h, the surface energy of the light-receiving surface 310 of the heterojunction cell 30 is raised to greater than 72mN/m, and the surface energy of the backlighting surface 311 of the heterojunction cell 30 remains unchanged.

Post-treatment 4: heating at 180°C is performed for 1h, the surface energy of the light-receiving surface 310 of the heterojunction cell 30 is enhanced to 44mN/m, and the surface energy of the backlighting surface 311 is enhanced to 44mN/m.

Post-treatment 5: air plasma, 50W, 30s, the surface energy of the light-receiving surface 310 of the heterojunction cell 30 is enhanced to 40mN/m, and the surface energy of the backlighting surface 311 of the heterojunction cell 30 is enhanced to 40mN/m.

**Table 2 Improvement of surface energy of the light-receiving surface 310 of the heterojunction cell 30 caused by different post-treatments**

| Sample | The surface energy (mN/m) of the light-receiving surface 310 of the heterojunction cell 30 | The surface energy (mN/m) of the backlighting surface 311 of the heterojunction cell 30 | The peeling energy (J/m²) between the light-receiving surface 310 of the heterojunction cell 30 and EVA |
|---|---|---|---|
| heterojunction cell 30 | 34 | 34 | 430 |
| heterojunction cell 30 and post-treatment 1 | 48 | 34 | 510 |
| heterojunction cell 30 and post-treatment 2 | 58 | 34 | 660 |
| heterojunction cell 30 and post-treatment 3 | greater than 72 | 34 | 710 |
| heterojunction cell 30 and post-treatment 4 | 44 | 44 | / |
| heterojunction cell 30 and post-treatment 5 | 40 | 40 | / |

As can be seen from Table 2 above, after post-treatment 3 on the heterojunction cell 30, it can better enhance the surface energy of the light-receiving surface 310 of the heterojunction cell 30, so as to better improve the peeling energy between the light-receiving surface 310 of the heterojunction cell 30 and the EVA (ethylene-vinyl acetate copolymer), which is the peeling energy between the encapsulating adhesive film layer 20 and the transparent conductive film layer 32, thereby enhancing the connection reliability of the encapsulating adhesive film layer 20 and the heterojunction cell 30.

As shown in FIG. 3, a photovoltaic assembly 100 according to an embodiment in a third aspect of the present disclosure includes the heterojunction cell 30 of any of the above embodiments.

In conjunction with FIG. 3, the photovoltaic assembly 100 includes a cover plate 10, an encapsulating adhesive film layer 20, and a heterojunction cell 30. The heterojunction cell 30 is a main part of the photovoltaic assembly 100 and can generate electricity. The cover plate 10 can increase the light transmittance of the photovoltaic assembly 100 and reduce the reflectivity, thereby improving the power generation efficiency of the photovoltaic assembly 100. The encapsulating adhesive film layer 20 mainly fixes the cover plate 10 and the heterojunction cell 30 and connects the cover plate 10 with the heterojunction cell 30 together, so that the photovoltaic assembly 100 forms as an integrated part. The encapsulating adhesive film layer 20 is generally made from a material that is light transparent, adhesive, resistant to ultraviolet rays and high temperature and that has a low permeability and a high resistivity.

As shown in FIG. 3, the encapsulating adhesive film layer 20 is provided between the heterojunction cell 30 and the cover plate 10. The encapsulating adhesive film layer 20 can connect the cover plate 10 to the heterojunction cell 30 and can fix them together. The encapsulating adhesive film layer 20 is disposed between the cover plate 10 and the heterojunction cell 30. In an actual application of the photovoltaic assembly 100, sunlight will first pass through the cover plate 10, then pass through the encapsulating adhesive film layer 20, and finally arrive at the heterojunction cell 30. The heterojunction cell 30 generates photovoltaic power. A peeling energy value between the heterojunction cell 30 and the encapsulating adhesive film layer 20 is greater than or equal to 200J/m².

It should be noted that, the peeling energy represents a peeling force between two objects. Ggenerally, a greater peeling energy value represents a greater peeling force between two objects and a greater connection strength between the two objects. A smaller peeling energy value represents a smaller peeling force between two objects and a smaller connection strength between the two objects. The peeling energy value between the surface of the heterojunction cell 30 and the encapsulating adhesive film layer 20 is greater than or equal to 200J/m², so that the peeling energy value between the surface of the heterojunction cell 30 and the encapsulating adhesive film layer 20 can be ensured to be in a reliable range. Therefore, the peeling energy value should not be too small. In this way, it can avoid a decrease in the peeling energy between the encapsulating adhesive film layer 20 and the heterojunction cell 30 in the assembling process of the photovoltaic assembly 100, and thus a reduction in the reliability of the connection between the encapsulating adhesive film layer 20 and the heterojunction cell 30.

In some examples of the present disclosure, the peeling energy value between the heterojunction cell 30 and the encapsulating adhesive film layer 20 is greater than or equal to 400J/m². The peeling energy value between the surface of the heterojunction cell and the encapsulating adhesive film layer 20 can be set to be greater than or equal to 400J/m², which further avoids a decrease in the peeling energy between the encapsulating adhesive film layer 20 and the heterojunction cell 30 during the assembly process of the photovoltaic assembly 100 and a reduction in the reliability of the connection between the encapsulating adhesive film layer 20 and the heterojunction cell 30.

In some examples of the present disclosure, as shown in FIG. 2, the heterojunction cell 30 includes: a cell body 31, a transparent conductive film layer 32, and a metal electrode 33. The cell body 31 is a main part of the heterojunction cell 30. The transparent conductive film layer 32 can cooperate with the metal electrode 33, so as to realize the conductive function of the heterojunction cell 30. The transparent conductive film layer 32 is provided on the cell body 31, so that the transparent conductive film layer 32 can be connected with the cell body 31 and can act on the heterojunction cell 30 to play a role of electric conduction. The metal electrode 33 is provided on a surface of the transparent conductive film layer 32 that faces away from the cell body 31. The encapsulating adhesive film layer 20 is provided on a surface of the metal electrode 33 that faces away from the cell body 31, so that the metal electrode 33 can better connect and cooperate with the transparent conductive film layer 32.

In some examples of the present disclosure, as shown in FIG. 2 and 3, the cover plate 10 includes a first cover plate 11 and a second cover plate 12. The encapsulating adhesive film layer 20 includes a first encapsulating adhesive film layer 21 and a second encapsulating adhesive film layer 22. The first encapsulating adhesive film layer 21 is disposed between the first cover plate 11 and the heterojunction cell 30, and the second encapsulating adhesive film layer 22 is disposed between the second cover plate 12 and the heterojunction cell 30. The peeling energy value between the heterojunction cell 30 and the first encapsulating adhesive film layer 21 is greater than or equal to 200J/m².

In some examples of the present disclosure, with reference to FIG. 2 and 3, the cell body 31 has a light-receiving surface 310 and a backlighting surface 311. The transparent conductive film layer 32 includes a first transparent conductive film layer 320 and a second transparent conductive film layer 321. The first transparent conductive film layer 320 is disposed on the light-receiving surface 310, and the second transparent conductive film layer 321 is disposed on the backlighting surface 311. The peeling energy value between a surface of the first transparent conductive film layer 320 and the first encapsulating adhesive film layer 21 is greater than or equal to 200J/m².

It can be understood that, the cell body 31 or the heterojunction cell 30 has two surfaces, with the surface that primarily receives sunlight being a front surface, i.e., the light-receiving surface 310, and another surface opposite to the front surface is a surface of the cell body 31 or the heterojunction cell 30 that secondarily receiving sunlight, i.e., the backlighting surface 311. The first transparent conductive film layer 320 may cooperate with the metal electrode 33 disposed on one side of the light-receiving surface 310 to play a role of electric conduction on the light-receiving surface 310 of the cell body 31. The second transparent conductive film layer 321 may cooperate with the metal electrode 33 disposed on one side of the backlighting surface 311 to play a role of electric conduction on the backlighting surface 311 of the cell body 31.

The first transparent conductive film layer 320 is disposed on the first encapsulating adhesive film layer 21. The first encapsulating adhesive film layer 21 is disposed on the first cover plate 11. The first encapsulating adhesive film layer 21 is disposed between the first cover plate 11 and the first transparent conductive film layer 320. The second transparent conductive film layer 321 is disposed on the second encapsulating adhesive film layer 22. The second encapsulating adhesive film layer 22 is disposed on the second cover plate 12. The second encapsulating adhesive film layer 22 is disposed between the second cover plate 12 and the second transparent conductive film layer 321. After the sunlight passes through the first cover plate 11 and the first encapsulating adhesive film layer 21, it reaches the first transparent conductive film layer 320 for electric conduction, and reaches the second encapsulating adhesive film layer 22 through the gap between the heterojunction cells 30. The sunlight passes through the second encapsulating adhesive film layer 22 to reach the second cover plate 12, and is reflected by the second cover plate 12. The reflected sunlight irradiates on the second transparent conductive film layer 321 through the second encapsulating adhesive film layer 22, that is, returns back to the heterojunction cell 30 again, so as to increase the conversion efficiency of the heterojunction cell 30.

In addition, the peeling energy value between the heterojunction cell 30 and the surface of the first transparent conductive film layer 320 and the first encapsulating adhesive film layer 21 is greater than or equal to 200J/m², so that the peeling energy value between the heterojunction cell 30 and the surface of the first transparent conductive film layer 320 and the first encapsulating adhesive film layer 21 can be ensured to be in a reliable range. The peeling energy value should not be too small. In this way, it can avoid a decrease in the peeling energy between the heterojunction cell 30 and the first encapsulating adhesive film layer 21 and the surface of the first transparent conductive film layer 320 during the assembly process of the photovoltaic assembly 100 and thus a reduction in the reliability of the connection between the heterojunction cell 30 and the first encapsulating adhesive film layer 21 and the heterojunction cell 30.

Further, the peeling energy value between a surface of the second transparent conductive film layer 321 and the second encapsulating adhesive film layer 22 is greater than or equal to 200J/m². Similarly, this can ensure that the peeling energy value between the surface of the second transparent conductive film layer 321 and the second encapsulating adhesive film layer 22 is in a reliable range. The peeling energy value should not be too small. Therefore, it can avoid a decrease in the peeling energy between the second encapsulating adhesive film layer 22 and the surface of the second transparent conductive film layer 321 during the assembly process of the photovoltaic assembly 100, and thus a reduction in the reliability of the connection between the second encapsulating adhesive film layer 22 and the heterojunction cell 30.

In some examples of the present disclosure, the transparent conductive film layer 32 is a transparent conductive film layer 32 in which the mass concentration of indium trioxide is greater than 90%. It should be noted that the main components of the transparent conductive film layer 32 are indium trioxide and tin dioxide. Indium trioxide is a new n-type transparent semiconductor functional material with a wide band gap, a smaller resistivity, and higher catalytic activity, and is widely used in the fields of optoelectronics, gas sensors, and catalysts. The mass concentration of indium trioxide in the transparent conductive film layer 32 is greater than 90%, which can make the transparent conductive film layer 32 have better relevant performance and achieve a better transparent and conductive effect. In addition, the surface energy of the transparent conductive film layer 32 can be improved to a certain extent, and the decline degree of the surface energy of the surface of the transparent conductive film layer 32 during the preparation process of the heterojunction cell 30 can be reduced, so that the peeling energy between the encapsulating adhesive film layer 20 and the surface of the transparent conductive film layer 32 can be improved.

Optionally, the transparent conductive film layer 32 is a transparent conductive film layer 32 in which the mass concentration of indium trioxide is greater than 95%. The mass concentration of indium trioxide in the transparent conductive film layer 32 being set to be greater than 95% generates a better relevant performance of the transparent conductive film layer 32 and a better transparent conductive effect, further improves the surface energy of the transparent conductive film layer 32, reduces the decline degree of the surface energy of the electrode fixing surface 34 during the preparation process of the heterojunction cell 30, and enhances the peeling energy between the encapsulating adhesive film layer 20 and the surface of the transparent conductive film layer 32.

In some examples of the present disclosure, referring to FIG. 2 and 3, the cell body 31 includes a silicon substrate 312 and an amorphous silicon layer 313. The amorphous silicon layer 313 is disposed on a surface of the silicon substrate 312. The transparent conductive film layer 32 is disposed on a surface of the amorphous silicon layer 313. The surface of the silicon substrate 312 is a textured surface, and the textured surface has an average size of less than 2µm. The silicon substrate 312 is made from a material used for production of a heterojunction cell. The amorphous silicon layer 313 is provided on a surface of the silicon substrate 312. The amorphous silicon layer 313 is provided on the light-receiving surface 310 and the backlighting surface 311 of the silicon substrate 312 at the same time, so that both the light-receiving surface 310 and the backlighting surface 311 of the silicon substrate 312 can form the crystalline silicon substrate 312. The surface of the silicon substrate 312 is set as a textured surface, and the textured surface has an average size of less than 2µm. It is to be noted that, the textured surface of this size, compared to a polished surface with the same size, is easier to achieve high surface energy after UV irradiation. Therefore, it can avoid a decrease in the peeling energy between the encapsulating adhesive film layer 20 and the transparent conductive film layer 32 and thus avoid a reduction in the reliability of the connection between the encapsulating adhesive film layer 20 and the heterojunction cell 30.

Of course, the average size of the textured surface is greater than or equal to 1.3µm and less than or equal to 1.7µm. Thereby, the range of the average size of the textured surface is defined, so that the average size of the textured surface is more reasonable, and it is easier for the textured surface to achieve a high surface energy, thereby avoiding a decrease in the peeling energy between the encapsulating adhesive film layer 20 and the transparent conductive film layer 32 and thus avoiding a reduction in the reliability of the connection between the encapsulating adhesive film layer 20 and the heterojunction cell 30.

It should be noted that the size of the textured surface is a Feret diameter of a pyramid. Within a unit area of the light-receiving surface 310 of the silicon substrate 312, a percentage of the number of pyramids with a Feret diameter in a range of 1µm to 1.5µm is 20% to 40%, a percentage of the number of pyramids with a Feret diameter in a range of 1.5µm to 2µm is 20% to 40%. Furthermore, within a unit area of the light-receiving surface 310 of the silicon substrate 312, a percentage of the number of pyramids with a Feret diameter of less than 1µm is no greater than 10%, a percentage of the number of pyramids with a Feret diameter in the range of 2µm to 2.5µm is 5% to 25%, and a percentage of the number of pyramids with a Feret diameter greater than 2.5µm is less than 5%. Preferably, on the light-receiving surface 310 of the silicon substrate 312, the Feret diameter of each pyramid is not greater than 3 µm.

Within a unit area of the backlighting surface 311 of the silicon substrate 312, a percentage of the number of pyramids with a Feret diameter in the range of 1.5µm to 2µm is 10% to 30%, a percentage of the number of pyramids with a Feret diameter in the range of 2µm to 2.5µm is 20% to 40%. Further, within a unit area of the backlighting surface 311 of the silicon substrate 312, a percentage of the number of pyramids with a Feret diameter less than 1µm is no greater than 10%, a percentage of the number of pyramids with a Feret diameter in the range of 1µm to 1.5µm is 10% to 20%, a percentage of the number of pyramids with a Feret diameter in the range of 2.5µm to 3µm is 5% to 20%, and a percentage of the number of pyramids with a Feret diameter greater than 3µm is less than 5%. Preferably, on the backlighting surface 311 of the silicon substrate 312, the Feret diameter of each of the pyramids is not greater than 4µm.

From the above, multiplying the number of pyramids in different diameter ranges by corresponding diameters respectively to obtain a value and then dividing the value by the total number of pyramids can obtain the average size of the textured surface. The average size of the textured surface is greater than or equal to 1.3µm and the average size of the textured surface is less than or equal to 1.7µm.

The following is a detailed description of the test method for the surface energy of the heterojunction cell 30.

Inks with different surface energy values are selected to be respectively applied onto the surface of the heterojunction cell 30 via brush coating. The expansion or contraction of the inks within 5 seconds is observed. If the surface energy of the heterojunction cell 30 is less than or equal to the surface energy value of the ink, the ink does not expand or contract. If the surface energy of the heterojunction cell is greater than the surface energy value of the ink, the ink expands. The upper limit of the surface energy of the test ink is 72mN/m.

Preparation process: the heterojunction cell 30 can be prepared by texturing, chemical vapor deposition (CVD), physical vapor deposition (PVD), screen printing, low-temperature drying, curing, optical and thermal processing.

The heterojunction cell 30 having a high surface energy is realized by post-treatment, mainly by using a certain method to decompose the organic matter adsorbed on the surface of the heterojunction cell 30, including high-temperature treatment, ultraviolet (UV) illumination, plasma (plasma) treatment, and ozone (O₃) oxidation and so on.

The light-receiving surface 310 of the heterojunction cell 30 has an initial surface energy of 34mN/m, and the backlighting surface 311 has a surface energy of 34mN/m.

Post-treatment 1: the light-receiving surface 310 of the heterojunction cell 30 is irradiated by UV with 150W/m² at 60°C for a duration of 12h. The surface energy of the light-receiving surface 310 of the heterojunction cell 30 is enhanced to 48mN/m, and the surface energy of the backlighting surface 311 of the heterojunction cell 30 remains unchanged. The initial peeling energy of the module is 510J/m², which is higher than the peeling energy of the light-receiving surface 310 of the untreated heterojunction cell 30. In particular, after the DH and UV treatments, the peeling energy of the light-receiving surface 310 after the post-treatment 1 can be maintained at 390J/m², which is significantly improved compared to 130J/m² before the treatment. Therefore, it is conducive to improving the reliability of the module outdoors.

Post-treatment 2: the light-receiving surface 310 of the heterojunction cell 30 is irradiated by UV with 150W/m² at 60°C for a duration of 48h, the surface energy of the light-receiving surface 310 of the heterojunction cell 30 is enhanced to 58mN/m, and the surface energy of the backlighting surface 311 of the heterojunction cell 30 remains unchanged. The initial peeling energy of the photovoltaic assembly 100 is 660J/m², which is higher than the peeling energy of the light-receiving surface 310 of the untreated heterojunction cell 30. In particular, after the DH and UV treatments, the peeling energy of the light-receiving surface 310 after the post-treatment 1 can be maintained at 640J/m², which is a significantly improved compared to 130J/m²before the treatment and is substantially the same as the initial peeling energy.

Post-treatment 3: the light-receiving surface 310 of the heterojunction cell 30 is irradiated by UV with 150W/m² at 60°C for a duration of 168h, the surface energy of the light-receiving surface 310 of the heterojunction cell 30 is raised to greater than 72mN/m, and the surface energy of the backlighting surface 311 of the heterojunction cell 30 remains unchanged. The initial peeling energy of the photovoltaic assembly 100 is 660J/m², which is higher than the peeling energy of the light-receiving surface 310 of the untreated heterojunction cell 30. In particular, after the DH and UV treatments, the peeling energy of the light-receiving surface 310 after the post-treatment can rise to 1150J/m². It indicates that the cell surface that is adequately treated is bonded to an adhesive film, the bonding can be strengthened under the action of a certain temperature and UV light, which greatly enhances the outdoor reliability of the assembly.

The DH and UV treatments described above refer to continuous aging treatment for 200 hours under UV irradiation of not less than 170W/m² at a temperature of 85°C and a relative humidity of 85%. The UV spectrum shall conform to the description of IEC 61215-2:2016 on UV spectra.

Post-treatment 4: heating at 180°C is performed for 1h, the surface energy of the light-receiving surface 310 of the heterojunction cell 30 is enhanced to 44mN/m, and the surface energy of the backlighting surface 311 is enhanced to 44mN/m.

Post-treatment 5: air plasma, 50W, 30s, the surface energy of the light-receiving surface 310 of the heterojunction cell 30 is enhanced to 40mN/m, and the surface energy of the backlighting surface 311 of the heterojunction cell 30 is enhanced to 40mN/m.

**Table 3 Improvement of surface energy of the light-receiving surface 310 of the heterojunction cell 30 caused by different post-treatments**

| Sample | The surface energy (mN/m) of the light-receiving surface 310 of the heterojunction cell 30 | The surface energy (mN/m) of the backlighting surface 311 of the heterojunction cell 30 | Peeling energy (J/m²) between the light-receiving surface 310 of the heterojunction cell 30 and EVA | After the DH and UV treatments, peeling energy (J/m²) between the light-receiving surface 310 of the heterojunction cell 30 and EVA |
|---|---|---|---|---|
| heterojunction cell 30 | 34 | 34 | 430 | 130 |
| heterojunction cell 30 and post-treatment 1 | 48 | 34 | 510 | 390 |
| heterojunction cell 30 and post-treatment 2 | 58 | 34 | 660 | 640 |
| heterojunction cell 30 and post-treatment 3 | greater than 72 | 34 | 710 | 1150 |
| heterojunction cell 30 and post-treatment 4 | 44 | 44 | / | / |
| heterojunction cell 30 and post-treatment 5 | 40 | 40 | / | / |
| heterojunction cell 30 and post-treatment 2 | 58 | 34 | peeling energy with POE 570 | peeling energy with POE 500 |

As can be seen from Table 3 above, after post-treatment 3 on the heterojunction cell 30, it can better enhance the surface energy of the light-receiving surface 310 of the heterojunction cell 30, so as to better improve the peeling energy between the light-receiving surface 310 of the heterojunction cell 30 and the EVA (ethylene-vinyl acetate copolymer) or POE (polyethylene-octene elastomer), which is the peeling energy between the encapsulating adhesive film layer 20 and the transparent conductive film layer 32, thereby enhancing the connection reliability of the encapsulating adhesive film layer 20 and the heterojunction cell 30.

In the description of the present disclosure, it should be understood that orientations or positional relationships indicated by terms "center", "longitudinal", "transverse", "length", "width", "thickness", "upper", "lower", "front", "rear", "left", "right", "vertical", "horizontal", "top", "bottom", "inner", "outer", "axial", "radial" and "circumferential" are based on orientations or positional relationships shown in the drawings, are only for ease of description of the present disclosure and simplification of the description, rather than indicating or implying that an indicated device or element must have a particular orientation, be constructed and operated in a particular orientation, and therefore cannot be construed as limiting the present disclosure.

In the description of the present disclosure, "first feature" and "second feature" may include one or more such features. In the description of the present disclosure, "multiple" means two or more. In the description of the present disclosure, the first feature being "above" or "below" the second feature may include the first and second features being in direct contact, or the first and second features being in indirect contact via another feature between them. In the description of the present disclosure, the first feature being "above" or "on top of" the second feature indicates the first feature being directly above or diagonally above the second feature, or merely indicates that the first feature is horizontally higher than the second feature.

In the description of the present disclosure, the description with reference to the terms "one embodiment", "some embodiments", "exemplary embodiments", "example", "specific example", or "some examples", etc., means that specific features, structures, materials, or characteristics described in conjunction with the embodiment(s) or example(s) are included in at least one embodiment or example of the present disclosure. In the present disclosure, any illustrative reference to the above terms does not necessarily refer to the same embodiment(s) or example(s).

Although the embodiments of the present disclosure have been shown and described above, it can be appreciated by those of ordinary skill in the art that various changes, modifications, alternatives and variants can be made to the above embodiments without departing from the principle and the spirit of the present disclosure. The scope of the disclosure is defined by claims and equivalents thereof.

## Claims

1. A method for preparing a heterojunction cell, comprising:
manufacturing a heterojunction cell; and
irradiating a surface of the heterojunction cell using Ultraviolet (UV) light to obtain the heterojunction cell with a surface energy greater than 40mN/m.

2. The method for preparing the heterojunction cell according to claim 1, wherein said irradiating the surface of the heterojunction cell using the UV light comprises:
irradiating the surface of the heterojunction cell using a single type of UV light or a combination of multiple types of UV light.

3. The method for preparing the heterojunction cell according to claim 2, wherein said irradiating the surface of the heterojunction cell using the single type of UV light comprises:
irradiating the surface of the heterojunction cell using a single type of Ultraviolet C (UVC).

4. The method for preparing the heterojunction cell according to claim 3, wherein said irradiating the surface of the heterojunction cell using the single type of UV light comprises:
irradiating the surface of the heterojunction cell using a single type of UVC with a radiation intensity in a range of 100W/m² to 500W/m².

5. The method for preparing the heterojunction cell according to claim 3 or 4, wherein in said irradiating the surface of the heterojunction cell using the single type of UV light,
a duration of irradiation using the single type of UVC is t₁, t₁ satisfying a relationship of 10min≤t₁≤60min; and/or
an ambient temperature is T₁, T₁ satisfying a relationship of 20°C ≤ T₁ ≤ 200°C.

6. The method for preparing the heterojunction cell according to claim 2, wherein said irradiating the surface of the heterojunction cell using the combination of multiple types of UV light comprises:
irradiating the surface of the heterojunction cell using Ultraviolet A (UVA) and Ultraviolet B (UVB) or using Ultraviolet C (UVC) of different wavelengths.

7. The method for preparing the heterojunction cell according to claim 6, wherein said irradiating the surface of the heterojunction cell using the UVA and the UVB comprises:
irradiating the surface of the heterojunction cell using the UVA with a radiation intensity in a range of 100W/m² to 500W/m² and the UVB with a radiation intensity in a range of 100W/m² to 500W/m².

8. The method for preparing the heterojunction cell according to claim 6 or 7, wherein in said irradiating the surface of the heterojunction cell using the UVA and the UVB,
a duration of irradiation using the UVA and the UVB is t₂, t₂ satisfying a relationship of 1 day≤t₂≤7 days; and/or
an ambient temperature is T₂, T₂ satisfying a relationship of 20°C ≤ T₂ ≤ 200°C.

9. The method for preparing the heterojunction cell according to claim 6, wherein said irradiating the surface of the heterojunction cell using the UVC of different wavelengths comprises:
irradiating the surface of the heterojunction cell using UVC having a first wavelength and a radiation intensity in a range of 5W/m² to 30W/m² and UVC having a second wavelength and a radiation intensity in a range of 100W/m² to 500W/m², the first wavelength being less than the second wavelength.

10. The method for preparing the heterojunction cell according to claim 6 or 9, wherein in said irradiating the surface of the heterojunction cell using the UVC of different wavelengths,
a duration of irradiation using the UVC of different wavelengths is t₃, t₃ satisfying a relationship of 1min≤t₃≤20min; and/or
an ambient temperature is T₃, T₃ satisfying a relationship of 20°C ≤ T₃ ≤ 120°C.

11. The method for preparing the heterojunction cell according to claim 1, further comprising: after said irradiating the surface of the heterojunction cell using the UV light,
performing an optical and thermal treatment on the heterojunction cell; and
testing and sorting the heterojunction cell.

12. The method for preparing the heterojunction cell according to any of claims 1 to 11, wherein said manufacturing the heterojunction cell comprises:
manufacturing a cell body;
depositing a transparent conductive film layer on a front surface and a back surface of the cell body;
Providing a metal electrode on a surface of the transparent conductive film layer; and
drying and curing the metal electrode.

13. A heterojunction cell manufactured using the method for preparing a heterojunction cell according to any one of claims 1-12, wherein the heterojunction cell comprises: a cell body, a transparent conductive film layer, and a metal electrode, the transparent conductive film layer is disposed on the cell body, a surface at one side of the transparent conductive film layer that faces away from the cell body is an electrode fixing surface, and the electrode fixing surface has a surface energy that is greater than or equal to 40mN/m, and the metal electrode is provided on the electrode fixing surface.

14. The heterojunction cell according to claim 13, wherein the electrode fixing surface has a surface energy that is greater than or equal to 60mN/m and that is less than or equal to 80mN/m.

15. The heterojunction cell according to any of claims 13 to 14, wherein the cell body has a light-receiving surface and a backlighting surface, the transparent conductive film layer comprises a first transparent conductive film layer and a second transparent conductive film layer, the first transparent conductive film layer is provided on the light-receiving surface, and the second transparent conductive film layer is provided on the backlighting surface, a surface at one side of the first transparent conductive film layer that faces away from the light-receiving surface is a first electrode fixing surface, a surface at one side of the second transparent conductive film layer that faces away from the backlighting surface is a second electrode fixing surface,
the first electrode fixing surface has a surface energy greater than or equal to 40mN/m; and/or
the second electrode fixing surface has a surface energy greater than or equal to 40mN/m.

16. The heterojunction cell according to any of claims 13 to 15, wherein the cell body comprises a silicon substrate and an amorphous silicon layer, the amorphous silicon layer is disposed on the silicon substrate, the transparent conductive film layer is disposed on the amorphous silicon layer, a surface of the silicon substrate is a textured surface, and the textured surface has an average size of less than 2 µ m.

17. The heterojunction cell according to claim 16, wherein the textured surface has an average size greater than or equal to 1.3 µ m and less than or equal to 1.7 µ m.

18. A photovoltaic assembly comprising the heterojunction cell according to any one of claims 13-17.
